Europäisches Patentamt

European Patent Office

Office européen des brevets

(11) Veröffentlichungsnummer: **0 450 372 A2**

# (12) EUROPÄISCHE PATENTANMELDUNG

(21) Anmeldenummer: 91104081.4

(22) Anmeldetag: 16.03.91

(51) Int. Cl.5: **H01L 39/22**

(30) Priorität: 31.03.90 DE 4010489

(43) Veröffentlichungstag der Anmeldung:
09.10.91 Patentblatt 91/41

(84) Benannte Vertragsstaaten:
DE FR GB IT

(71) Anmelder: **DORNIER LUFTFAHRT GMBH**
**Postfach 3**
**W-8031 Wessling/Oberpfaffenhofen(DE)**

(72) Erfinder: **Schröder, Hehrwart, Dr. rer. nat.**
**Dreilindenstrasse 10**
**W-7770 Überlingen-Hödingen(DE)**
Erfinder: **Moll, Michael, Dipl.-Ing.**
**Weildorfer Strasse 6**
**W-7777 Salem 3(DE)**
Erfinder: **Müller, Wilhelm, Dipl.-Ing.**
**Muschelweg 1**
**W-7775 Bermatingen-Ahausen(DE)**

(74) Vertreter: **Landsmann, Ralf, Dipl.-Ing.**
**c/o DORNIER GMBH Postfach 1420**
**W-7990 Friedrichshafen 1(DE)**

(54) Supraleitendes Element.

(57) Supraleitendes Element, insbesondere für einen Detektor für elektromagnetische Strahlung im IR-Bereich bis zu Dezimeterwellen, mit folgendem Aufbau: Supraleiter ($S_1$), Barriere (B), Supraleiter ($S_2$), Isolator (I) und Supraleiter ($S_3$). Der Supraleiter ($S_1$) ist für die elektromagnetische Strahlung durchlässig. Diese beeinflusst den zwischen $S_1$ und $S_2$ abgegriffenen Signalstrom in der Barriere (B). Durch Verändern der Arbeitsspannung zwischen $S_1$ und $S_2$ und Anlegen eines Steuerstromes für die Energielücke durch den Supraleiter ($S_3$) können die Frequenzen eingestellt werden, für die der Sensor maximal empfindlich sein soll.

EP 0 450 372 A2

## Fig. 1

Signalstrom

$S_1$  B  I  $S_3$

Steuerstrom für Energielücke

Arbeitsspannung

Die Erfindung betrifft ein supraleitendes Element nach dem Oberbegriff des Anspruchs 1.

Im Spektralbereich von Infrarot (IR) bis zu Dezimeterwellen (Mikrowellen) werden heute verschiedene Detektoren eingesetzt. Gegenwärtig gibt es jedoch keinen Detektor, der den genannten Spektralbereich mit maximaler Empfindlichkeit detektiert. Supraleitende Tunnelelemente detektieren elektromagnetische Strahlung im Gegensatz zu konventionellen Detektoren um mehrere Größenordnungen empfindlicher.

Als weiterer großer Vorteil ist die extrem kurze Ansprechzeit von supraleitenden Tunnelelementen zu nennen. Sie liegt heute bei Hochtemperatur-Supraleitern in der Größenordnung von pico-sek ($t_{min} \geq e \cdot \Phi_0/\Delta$; wobei e = Elektronenladung, $\Phi_0$ = Flußquant und $\Delta$ = Energielücke ist).

Supraleitende Tunnelelemente detektieren elektromagnetische Strahlung auf zwei verschiedene Arten: Als Breitband-Detektor oder als frequenzselektiver Detektor. Die bekannten Tunnelelemente sind starr, das heißt für frequenzselektive Detektion kann der Spektralbereich nicht verändert werden.

Allgemein gilt für Tunnelelemente, daß eine Grenze in Richtung kleiner Wellenlängen existiert, die durch die Energielücke im Anregungsspektrum des Supraleiters vorgegeben ist.

Die Energielücke ist temperaturabhängig. Sie erreicht bei T = 0 theoretisch ihren größten Wert. Dies bedeutet, daß mit niedrigeren Temperaturen auch die kurzwellige Detektionsgrenze immer weiter in Richtung kleinerer Wellenlängen verschoben wird.

Wegen der Abhängigkeit der Ansprechzeit und der Schaltzeit von der Energielücke wird auch diese mit abnehmender Temperatur immer geringer. Mit abnehmender Temperatur nimmt darüberhinaus die Rauschtemperatur ab und die Empfindlichkeit zu.

Zwei verschiedene Tunneleffekte können für die Detektion elektromagnetischer Strahlung ausgenutzt werden. Die Dicke der Barriere bestimmt die Art des Effektes. Der prinzipielle Aufbau eines Tunnelelements besteht aus zwei durch eine Barriere getrennten Supraleitern. Bei Barrierendicken mit mehr als 1,5 nm können nur noch Einzelelektronen tunneln. Bei Dicken um 1 nm tunneln auch Cooper-Paare.

Nachteilig bei den bekannten supraleitenden Sensorelementen ist, daß sie starr sind, das heißt, daß sie nicht auf verschiedenen Frequenzbereichen arbeiten können.

Aufgabe der Erfindung ist es, ein supraleitendes Element vorzuschlagen, mit dem ein Sensor gebaut werden kann, bei dem die empfindlichen Frequenzbereiche einstellbar sind.

Diese Aufgabe wird erfindungsgemäß gelöst von einem supraleitenden Element mit den Merkmalen des Anspruchs 1. Ausgestaltungen der Erfindung und Anwendungen sind Gegenstände der Unteransprüche.

Das erfindungsgemäße supraleitende Element besteht aus den Schichten Supraleiter $S_1$, der bei der Anwendung als Sensor oder Lichtemitter für die Strahlung durchlässig ist, Barriere B, Supraleiter $S_2$, Isolator I, Supraleiter $S_3$. Der Supraleiter $S_3$ weist Anschlüsse für einen Steuerstrom auf, zwischen den Supraleitern $S_1$ und $S_2$ ist eine Arbeitsspannung anlegbar und der Signalstrom wird zwischen den Supraleitern $S_1$ und $S_2$ abgegriffen. Bei der Anwendung als Sensor oder als Sender für elektromagnetische Strahlung erfolgt die Einkoppelung der elektromagnetischen Strahlung direkt durch die zwischen Strahlung und Barriere B liegende Schicht $S_1$ (diese ist optisch dünn). Die ganze Barrierefläche wird dadurch zur Detektortläche. Erfindungsgemäß ist die Barriere eine dichte Schicht mit einer Dicke < 5 nm. Die Dicke der Barriere beträgt für das Einzelelektronentunneln bevorzugt zwischen 2 und 4 nm und für das Josephsontunneln bevorzugt zwischen 1 und 1,5 nm. Die Barriere sollte dicht in dem Sinn sein, daß sie frei von Mikrolöchern ist. Die Barriere weist bevorzugt eine gleichmäßige Dicke auf, sie sollte im wesentlichen der Kontur der benachbarten Supraleiter $S_1$ und $S_2$ folgen. Da zu große Dickeschwankungen zu einem Kurzschluß führen können, sollten solche vermieden sein.

Das Tunnelelement ist so aufgebaut, daß die Energielücke und die Arbeitsspannung in Abhängigkeit zur Energielücke gesteuert werden können. Da die größte Empfindlichkeit dieser supraleitenden Tunnelelemente in der Nähe der Energielücke ist, ist mit der Erfindung erstmals eine frequenzselektive Detektion im Spektralbereich von etwa IR bis Dezimeterwellen mit gleicher maximaler Empfindlichkeit durch Anpassung der Energielücke an die gewünschte Wellenlänge möglich. Das Durchfahren des Spektralbereichs mit Josephson-Logik kann in der Größenordnung pico-sek erfolgen. Bei Breitbandbetrieb kann die Bandbreite des Spektralbereichs über die Energielücke gesteuert werden.

Zur extremen Empfindlichkeit und extrem kurzen Ansprechzeit kommt also als Vorteil die Fähigkeit hinzu, mit diesen Eigenschaften alle Wellenlängen ab einer kurzwelligen Grenze detektieren zu können. Durch diese Fähigkeiten entsteht ein neuer Detektor. Die Schichten des Detektors sind bevorzugt auf einer Substratgrundplatte aufgebracht.

In einer bevorzugten Ausführungsform ist das supraleitende Element quaderförmig aufgebaut, wobei der (strahlungsdurchlässige) Supraleiter $S_1$ den Boden bildet, die Substratgrundplatte die gegenüberliegende Deckfläche und die Kontaktbahnen zu den einzelnen Schichten auf gegenüberliegenden Seitenflächen angeordnet sind. Ein solcher supraleitender Element-Würfel ist besonders kompakt aufgebaut, hat eine relativ große empfindliche Fläche, wenn er als Sensor betrieben wird (Supraleiter $S_1$) und kann, da keine Überstände daneben vorhanden sind, mit gleichen Elementen zu einem Sensorfeld zusammengesetzt werden, bei dem dann die empfindlichen Flächen aneinander liegen.

In einer Ausführungsform werden die Schichten, insbesondere die Barriere B durch Molekularstrahlepitaxie aufgebracht, was zu definierten Schichtdicken und einer ausreichenden Barrierendichte (Freiheit von Löchern) führt. Durch diese Fertigungstechnik der supraleitenden Tunnelelemente (dies gilt für Einzelelektronen-und Josephson-Tunnelelemente) wird das Tunnelelement mit definierten Eigenschaften in großer Stückzahl reproduzierbar.

Ein auf Supraleitungsbasis arbeitender Multispektralsensor kann als Einzelelement-Detektor ausgelegt sein oder in großer Zahl von erfindungsgemäßen Sensorelementen in einem CCD-Feld (Charge Coupled Device) angeordnet sein. Die Größe eines einzelnen Sensorelements muß dabei mindestens der Größe des ersten Beugungsringes des langwelligsten Teiles der zu detektierenden Strahlung, also eines Airy-Scheibchens, entsprechen. Hier ist eine Anpassung an das zu detektierende Spektrum erforderlich.

Der Spektralbereich ist ansonsten mit Hilfe eines Rechners frei wählbar. Die Detektionsart und mögliche Kombinationen können programmiert werden. Zum Multispektralsensor gehört eine Steuerelektronik, die konventionell oder auf Supraleitungsbasis angefertigt sein kann. Die Steuerelektronik berechnet die Steuergrößen und steuert damit den Sensor oder das Sensorfeld.

Die ganze Anordnung kann auch im Brennpunkt eines abbildenden Systems, wie z.B. eines Cassegrain-Spiegel-Systems eingebaut sein. Der Spiegel ist dann im Vergleich zum Sensorbaustein relativ groß, wodurch die Empfindlichkeit stark gesteigert wird. Der Multispektralsensor kann auch in größerer Zahl im Verbund betrieben werden. Der Datentransport sollte dann entweder mit supraleitenden Kabeln oder mit Hilfe eines Lichtleitersystems erfolgen. Ein zentraler Rechner steuert dann eine beliebige Anzahl solcher Multispektralsensoren, kontrolliert ihren Datenfluß und wertet ihn aus.

Wenn die digital anfallenden Signale mit einer Josephson-Logik gespeichert, verglichen und verarbeitet werden, eröffnet dieser Sensorbaustein in Kombination mit der Bildverarbeitung interessante Anwendungen in vielen Bereichen der Technik. Dies kann z.B. sein die Darstellung in Echtzeit von Objekten, welche durch Aerosole (Nebel, Wolken), Flüssigkeiten (Wasser, Blut) oder durch feste Stoffe (Bäume, Laub, Schnee, Schmutz) verdeckt sind.

Beispiele sind ein medizinischer Eingriff ohne direkten Sichtkontakt, die Suche von Verschütteten bzw. von Entführten, Bodenanalysen von einem Fahrzeug aus, ohne daß eine Entnahme von Proben notwendig ist oder die Hinderniswarnung bei Flugzeugen und Fahrzeugen.

Das beschriebene supraleitende Element eignet sich neben der Herstellung von empfindlichen Sensoren auch zur Herstellung von aktiven Strahlungsquellen für den gleichen Wellenlängenbereich. Dazu wird die Vorspannung etwas höher als die Energielücke eingestellt. Das dann erfolgende Aufbrechen von Cooper-Paaren bewirkt ein Aussenden von elektromagnetischer Strahlung (z.B. Mikrowellen) und Phonen. Eine mögliche Anwendung ist ein Radar. Da die Umschaltzeit von Senden auf Empfangen ebenfalls im picosek-Bereich erfolgt, kann das Element als Sender Mikrowellen aussenden und danach sofort auf Empfang, z.B. der gleichen Frequenz, eingestellt werden und so die Echos aufnehmen. Durch die hohe Empfindlichkeit des Sensors reichen niedrige Energien des Senders, was ein Aufspüren des Radars sehr erschwert.

Da beim Sendebetrieb auch Phononen frei werden, kann das Element auch als Sender und Empfänger akustischer Wellen eingesetzt werden. Die Frequenzen liegen bei den heute erreichbaren Supraleitertemperaturen im THz-Bereich (Anwendung Phononenspektroskopie), können aber bei Vorliegen von Stoffen, die bei relativ hohen Temperaturen supraleitend sind, auch im Ultraschallbereich oder gar im Schallbereich liegen. Der Schall wird z.B. durch eine feste, schalleitende Ankopplung an den Supraleiter $S_1$ eingeleitet oder ausgeleitet.

Eine weitere Anwendung ist die des Elements als supraleitendes Schaltelement oder als Josephson-Schaltelement in SQUID's oder Rechnern. Bei der Verwendung in einem Digitalrechner wird das Element durch einen digitalen Steuerstrom angesteuert. Durch die schnelle Schaltzeit und die kleine Größe des Elements sind Rechner mit hohen Leistungen aufbaubar.

Die Erfindung wird anhand von sechs Figuren näher erläutert.

Es zeigen:

Fig. 1 ein Schaltschema eines erfindungsgemäßen supraleitenden Elements,

Fig. 2 schematisch den Aufbau eines supraleitenden Elements,

Fig. 3 eine Ausführung eines Sensorelements,

Fig. 4 einen erfindungsgemäßen Sensor,

Fig. 5 einen Sensor mit einer Vielzahl von Sensorelementen,

Fig. 6 einen Sensor mit Kryostaten und Spiegelsystem.

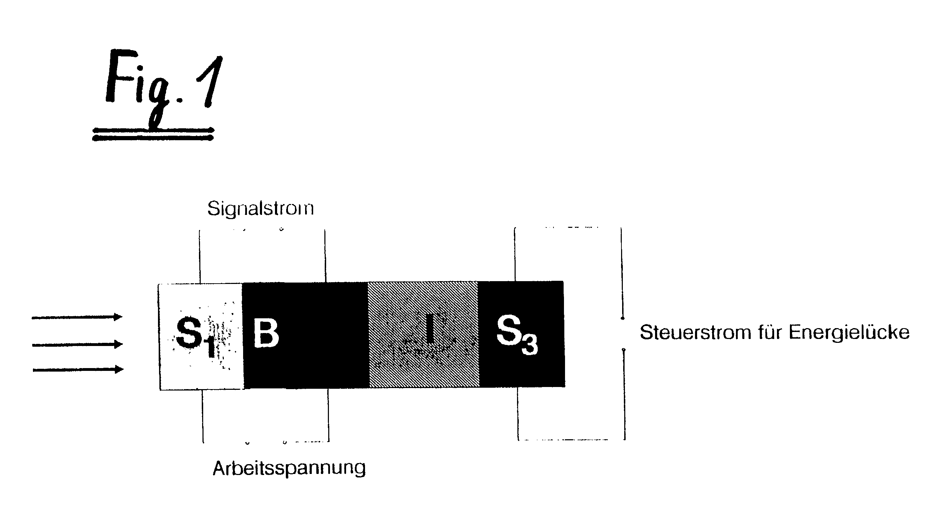

Fig. 1 zeigt das Schaltschema eines erfindungsgemäßen supraleitenden Elements (Tunnelelements) mit steuerbarer Energielücke und steuerbarer Arbeitsspannung. Das hier als Sensor verwendete Element hat folgenden Aufbau, beginnend auf der Seite auf der die elektromagnetische Strahlung einfällt; diese ist durch die Pfeile angedeutet.

- Supraleiter $S_1$, der für die elektromagnetische Strahlung durchlässig ist
- Barriere B
- Supraleiter $S_2$
- Isolator I
- Supraleiter $S_3$.

Das erfindungsgemäße Sensorelemente ist ein supraleitendes Tunnelelement. Neu ist die Strahlungseinkoppelung durch die erste supraleitende Schicht $S_1$ und die Vorrichtung zum Steuern der Energielücke und der Arbeitsspannung in Abhängigkeit von der Energielücke (Cooper-Paar- und Einzelelektronen-Tunneln). Die Supraleiter $S_1$ und $S_2$ sind durch die Barriere B mit vorgeschriebener Dicke und den erfindungsgemäßen Eigenschaften getrennt. Der Supraleiter $S_3$ ist durch die Isolierschicht I vom Supraleiter $S_2$ getrennt. Gezeichnet sind die Anschlüsse für die folgenden Ströme und Spannungen:

### Tunnel-Arbeitsspannung

Sie liegt zwischen den Tunnelschichten Supraleiter $S_1$ und Supraleiter $S_2$ an. Die Tunnel-Arbeitsspannung entscheidet darüber, wo in der Kennlinie gearbeitet wird. Sie entscheidet auch darüber, ob frequenzselektiv oder breitbandig detektiert wird. Die Tunnel-Arbeitsspannung muß dem jeweiligen Steuerstrom angepasst werden.

### Steuerstrom für die Energielücke

Er durchfließt die am Substrat (Q) liegende dritte Supraleitungsschicht. Das durch den Steuerstrom entstehende Magnetfeld durchsetzt die beiden supraleitenden Tunnelschichten. Die Stärke des Steuerstroms steuert die Größe der Energielücke und damit die Frequenz, für die der Detektor maximal empfindlich ist.

### Signalstrom

Er wird an den beiden supraleitenden Tunnelschichten $S_1$ und $S_2$ abgegriffen. In ihm steckt die Information der einfallenden Strahlung. Die Kontaktbahnen der Zuleitungen sind bevorzugt supraleitend, weil Signale im IR-Bereich schon im THz-Bereich liegen und nach wenigen Zentimetern im Normalleiter zerfließen würden. Es soll auch keine Wärme entstehen.

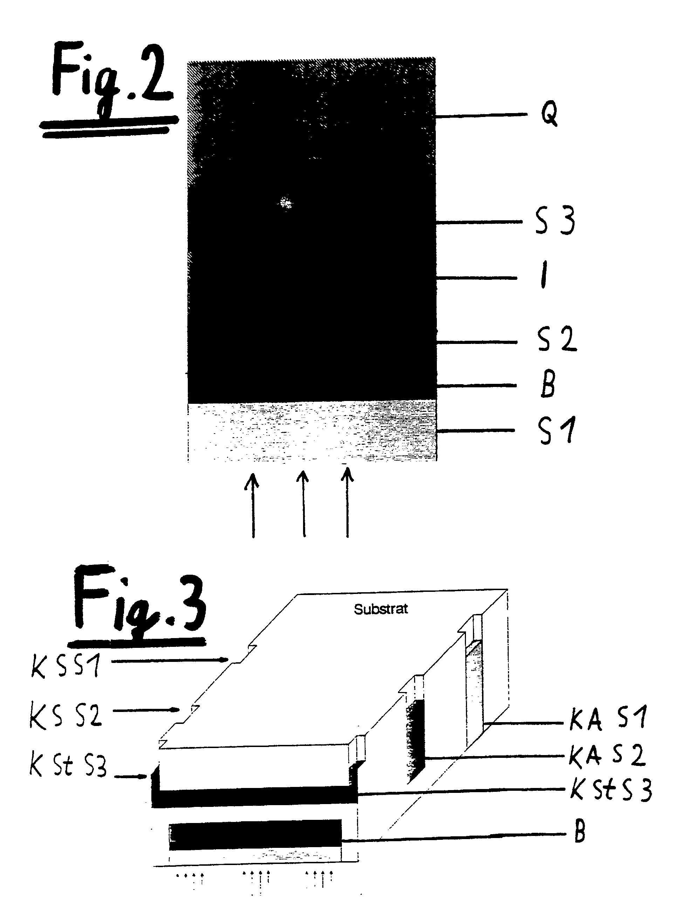

Fig. 2 zeigt den Aufbau eines supraleitenden Elements - wieder in der Anwendung als Sensor - mit den Elementen Substratgrundplatte Q, Supraleiter $S_3$ für den Steuerstrom, Isolator I (z.B. Si $O_2$), Supraleiter-Tunnelelektrode $S_2$, Barriere B (z.B. Si $O_2$) und Supraleiter-Tunnelelektrode $S_1$. Angedeutet durch die Pfeile ist wiederum die Richtung der einfallenden Strahlung. Bevorzugte Dicken sind für die Grundplatte Q z.B. 1 mm, für den Isolator I $\leq$ 100 nm, für die Barriere B eine Dicke im Bereich von 1 bis 1,5 nm und für die Supraleiter-Tunnelelektrode $S_1$ eine Dicke < 500 nm.

Die der Strahlung zugewandte supraleitende Schicht $S_1$ dient gleichzeitig als Stranlungsfenster. Um auch für IR-Strahlung durchlässig zu sein, muß die Schichtdicke kleiner als die Wellenlänge der zu detektierenden Strahlung sein.

Die Geschlossenheit und Dicke der Barriere B sind bestimmend für das Funktionieren und die Fähigkeit des Tunnelelements. Der Normalwiderstand bei Tunnelelementen und bei Josephson-Elementen auch der kritische Strom Ic hängen exponentiell von der Barrierendicke ab. Um die physikalischen Anforderungen einer definierten Schichtdicke und Barrierendichte (frei von Löchern) zu erfüllen, wird die Barriere B bevorzugt durch Molekularstrahlepitaxie erstellt. Die Dicken der zweiten und der dritten supraleitenden Schicht ($S_2$, $S_3$) werden von Optimierungsrechnungen bestimmt. Die Optimierung erfolgt z.B. bezüglich der Geometrie, der Schaltgeschwindigkeit, dem maximal geforderten Signal/Rauschverhältnis oder der Minimierung der Kapazitäten. Dies gilt auch für die Dicke der nachfolgenden Isolierschicht I (nicht dünner als 100 nm). Die dritte supraleitende Schicht $S_3$ liegt auf einem isolierenden Substrat auf (z.B. aus Quarz, Zerodur, Saphir oder Silizium). In dem hier gezeigten Ausführungsbeispiel ist das isolierenden Substrat eine Quarz-Grundplatte Q. Die drei supraleitenden Schichten und der Isolator können z.B. durch Sputtern oder ebenfalls durch Molekularstrahlepitaxie gefertigt werden.

Fig. 3 zeigt ein erfindungsgemäßes Sensorelement. Es ist hier in Form eines Quaders hergestellt, wobei Kontaktbahnen für

- die Tunnel-Arbeitsspannung,
- den Steuerstrom für die Energielücke und
- den Signalstrom

seitlich in den Quader eingelassen sind. Die Oberseite des Quaders wird von der Substratgrundplatte Q gebildet, die Unterseite von der ersten supraleitenden Schicht $S_1$, auf die die IR- oder die Mikrowellenstrahlung fällt (angedeutet durch die Pfeile).

Kontaktbahnen sind wie folgt bezeichnet:

- Kontaktbahn für Supraleiter 1 (Signalstrom) : KSS1
- Kontaktbahn für Supraleiter 2 (Signalstrom) : KSS2

- Kontaktbahn für Supraleiter 3 (Steuerstrom) : KStS3
- Kontaktbahn für Supraleiter 1 (Arbeitsspannung) : KAS1
- Kontaktbahn für Supraleiter 2 (Arbeitsspannung) : KAS2.

Das erfindungsgemäße Sensorelement funktioniert wie folgt:

Es gibt zwei Wechselwirkungen der elektromagnetischen Strahlung mit dem Tunnelelement, die hier Anwendung finden können. Einfallende Photonen können beim Einzelelektronentunnel photonenunterstütztes Tunneln auslösen und beim Cooper-Paar-Tunneln zusätzlich zum Aufbrechen der Cooper-Paare führen. Diese Prozesse sind möglich, wenn die elektromagnetische Strahlung ungehindert die Barriere B erreicht. Daraus folgt, daß der zwischen der Strahlung und der Barriere B liegenden Supraleiter $S_1$ optisch dünn ist. Einfallende Strahlung verändert also den Signalstrom und erlaubt so eine Detektion aller Wellenlängen bis zur kurzwelligen Grenze. Die Strahlungsinformation steckt im Signalstrom. Wegen der Abhängigkeit des zu detektierenden Spektralgebietes von der Energielücke wird die Größe der Energielücke mit dem Steuerstrom durch den Supraleiter $S_3$ verändert. Der Steuerstrom im Supraleiter $S_3$ erzeugt ein Magnetfeld. Dieses Magnetfeld verändert die Energielücke in den Supraleitern $S_1$ und $S_2$. Die Arbeitsspannung steht in Relation zur Energielücke (materialspezifisch). Sie entscheidet über den Detektionsmodus. Wird mit Hilfe der Arbeitsspannung eine gleiche oder grössere Energie als diejenige der Energielücke zugeführt, so brechen die Cooper-Paare auf und es entstehen unter anderem Mikrowellenstrahlung und Phononen mit derjenigen Frequenz, welche die jeweilige Energielücke aufweist. Die Auswahl des Detektionsmodus wird nachfolgend beschrieben:

Der Steuerstrom für die Energielücke wird von 0 Mikroampere bis zu einem Wert gesteuert, der die Energielücke gerade zu 0 werden lässt. Dabei wird der Spektralbereich von der oberen Grenzfrequenz im kurzwelligen Spektrum (maximale Energielücke) bis zum langwelligen Bereich (minimale Energielücke) durchfahren. Der Sensorstrom wächst proportional mit der Anzahl der einfallenden Photonen. Der Quantenwirkungsgrad liegt sehr nahe bei 1.

Die Arbeitsspannung muß in Abhängigkeit von der jeweiligen Energielücke gesteuert werden. Der Sensor wird durch eine von außen auf die Barriere einfallende elektromagnetische Schwingung auf der Grundschwingung oder Oberschwingung synchronisiert. Beim Josephson-Element sind solche synchronen Zustände als Stufen erkennbar. Das Josephson-Element ist in der Nähe der nullten Stromstufe ein breitbandiger Detektor, in der Nähe der ersten Stromstufe ein schmalbandiger frequenzselektiver Detektor.

Mit dem Steuerstrom für die Energielücke wird also die gewünschte Frequenz angewählt.

Die Detektionsart - breitbandig oder frequenzselektiv - und mögliche Kombinationen sind frei programmierbar. Die Steuer- und Auswerteelektronik berechnet die Steuergrößen zur Steuerung des Sensors bzw. des Sensorfelds und speichert, vergleicht und verarbeitet die anfallenden Signale. Wird im Modus "frequenzselektive Detektion" der gewählte Spektralbereich durchfahren, kann die Schaltung als Signalanalysator verwendet werden, das heißt, die Frequenzanteile des Signals mit ihren entsprechenden Amplituden können gemessen werden.

Wenn die Schaltung auf Breitband-Detektion umgeschaltet ist, detektiert sie gleichzeitig von der kurzwelligen Frequenzgrenze bis in das Dezimeter-Gebiet.

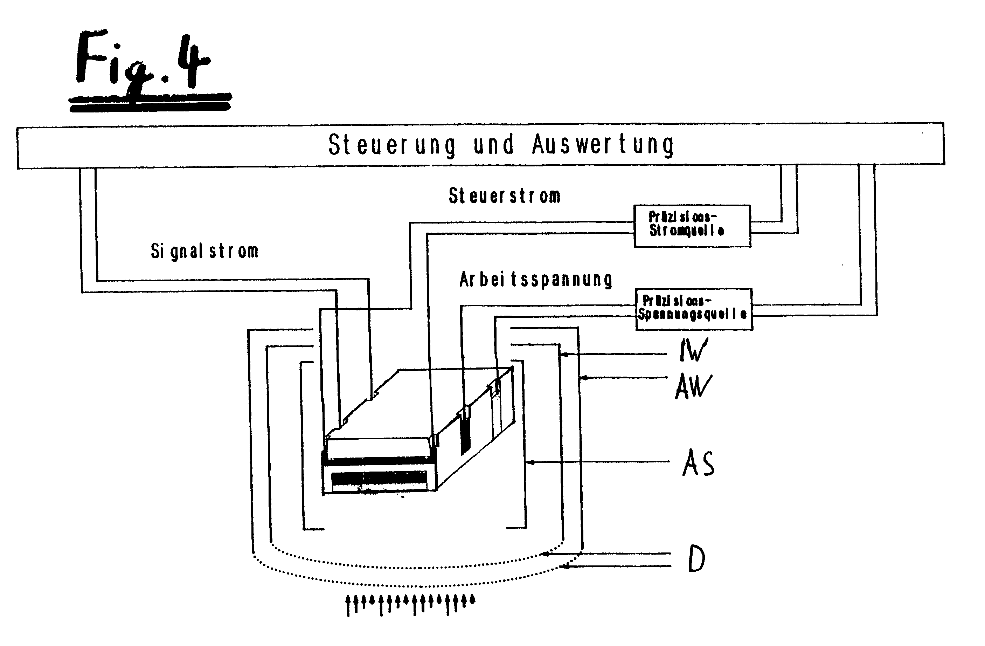

Fig. 4 zeigt eine Sensorschaltung mit den Elementen Steuerung und Auswertung, Präzisionsstromquelle und Präzisionsspannungsquelle. Das - in Fig.3 gezeigte - Sensorelement befindet sich hier in einem Kryostaten mit Innenwand IW, Außenwand AW und einem für elektromagnetische Strahlung in Domrichtung durchlässigen Dom D. Innerhalb des Miniaturkryostaten befindet sich eine Abschirmung AS aus einem Supraleiter, insbesondere einem Hochtemperatur-Supraleiter.

Die Steuergrößen für das Sensorelement werden durch die Steuer- und Auswerte-Elektronik bestimmt. Die Zeit zum Durchfahren des Spektralbereichs wird bei konventioneller Elektronik durch diese begrenzt.

Alle Leiterbahnen (KSS1 bis KAS2 in Fig. 3) am Sensor und alle Anschlüsse im Kryostaten sind supraleitend. Zum einen, um die zu erwartenden hohen Frequenzen bis weit in den THz-Bereich zu bearbeiten und weiterleiten zu können und zum anderen, um keine Wärme zu erzeugen. Die Arbeitsgeschwindigkeit des Multispektralsensors wird durch die Leistung des Rechners begrenzt, der die Steuerung des Sensors und die Auswertung der anfallenden Signale übernimmt. Um die Vorteile der digital anfallenden Signale voll nutzen zu können, sollte der Rechner auf Josephson-Logik umgestellt sein.

Die steuerbare Präzisionsstromquelle liefert den von der Steuer- und Auswerte-Elektronik geforderten Strom für den Betrieb des Sensorelements. Genauigkeitsanforderungen der Stromstärken liegen bei etwa 1 Mikroampere. Die steuerbare Präzisionsspannungsquelle liefert die von Steuer- und Auswerte-Elektronik geforderte Spannung. Charakteristische Spannungen liegen bei etwa 1 Millivolt.

Alle im Supraleitungsbereich befindlichen Sensor- und Elektronikteile werden bis auf das Strahlungsfenster D mit einem supraleitenden Schirm AS umgeben. Aufgrund des Meissner-Effekts wird vom Supraleiter AS (Hochtemperatursupraleiter) das Außenfeld im Inneren durch Abschirmströme völlig verdrängt. Dieser Vorteil der Supraleitung kann bei allen supraleitenden Schaltungen genutzt werden.

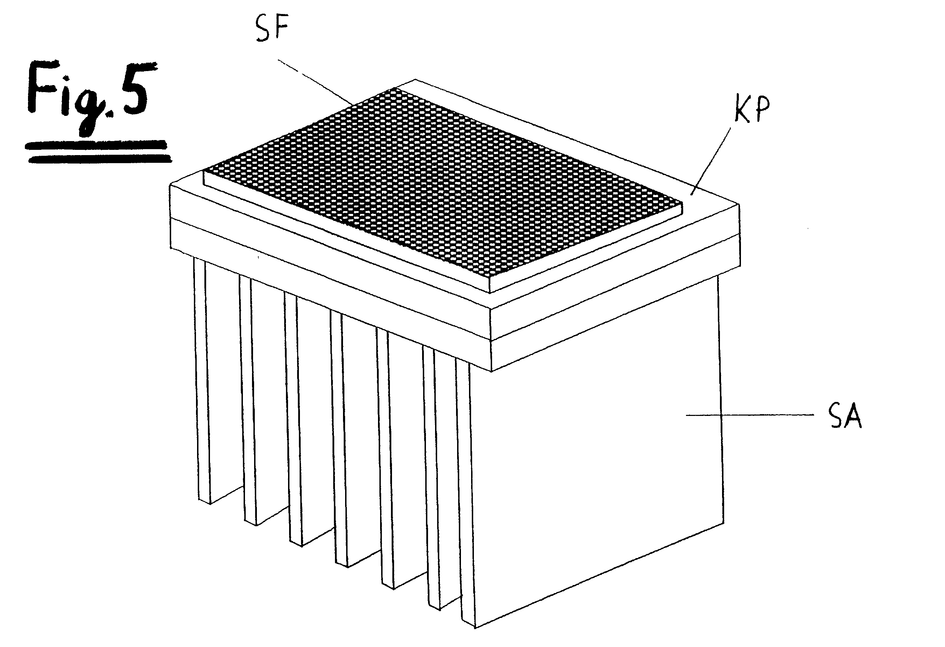

Fig. 5 zeigt schematisch einen betriebsbereiten Multispektralsensor mit CCD-Feld (Charge Coupled Device) auf Supraleitungsbasis. Die Sensorelemente bilden das Sensorfeld SF, das auf der Kontaktierungsplatte KP aufgebracht ist. Die Steuer- und Auswerte-Elektronik AS ist auf verschiedenen Karten verteilt, die senkrecht zum Sensorfeld SF auf der Rückseite der Kontaktierungsplatte KP angeordnet sind. Für die Elektronik sind hier Karten in Modulbauweise vorgeschlagen, die auf der Rückseite der Sensorplatte befestigt sind. Der Multispektralsensor erhält dadurch eine Würfelform, die auf einer Seite praktisch nur empfindliche Fläche (Sensorfeld SF) zeigt. Die kompakte Bauform bietet sich an, denn für die Verarbeitungsgeschwindigkeit gibt es in der Josephson-Elektronik zwei charakteristische Zeiten. Diese sind die Schaltgeschwindigkeit, die etwa in der Größenordnung pico-sek liegt, und die Signallaufzeit, die für einen Zentimeter Leitungslänge etwa $10^{-11}$ Sekunden beträgt. Um den Multispektralsensor mit einer Josephson-Logik optimal nutzen zu können, werden im Rechenteil alle Vorgänge in einem Rechen-Zyklus abgearbeitet .Dieser Zyklus ist von der Signallaufzeit und von der Schaltungsgeschwindigkeit abhängig und sollte minimal werden.

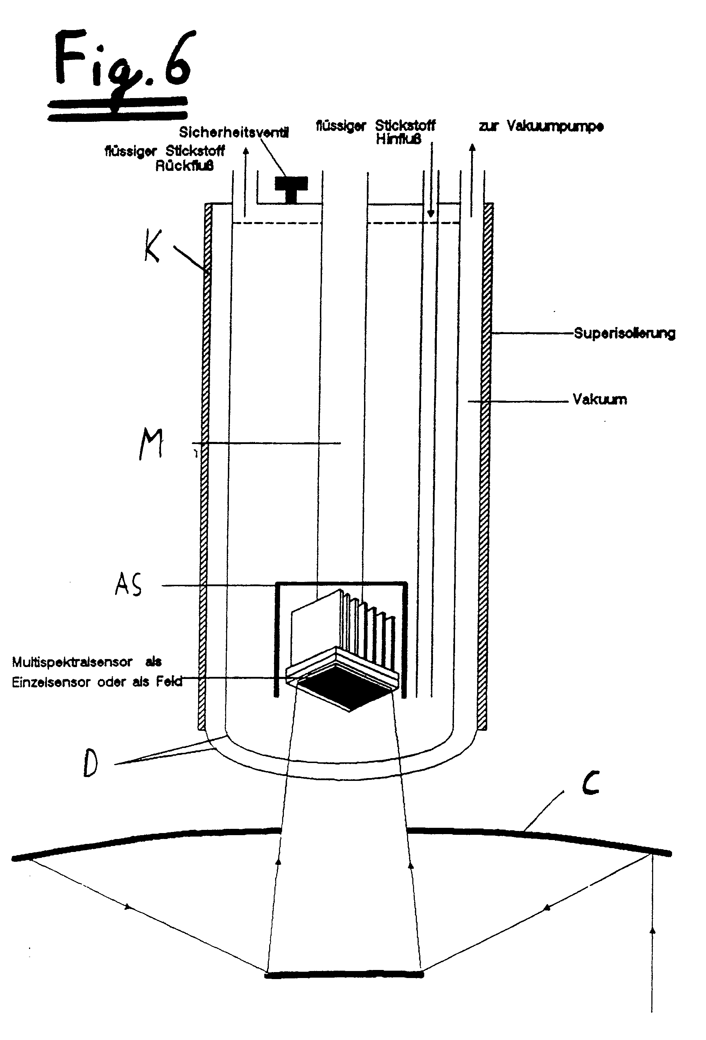

Fig. 6 zeigt ein multispektrales Empfängersystem mit Cassegrain-Spiegel C. Der aus Sensorelementen zusammengesetzte Sensor mit Steuer- und Auswerte-Elektronik - wie in Fig.5 gezeigt - befindet sich hier im Kryostaten K im Brennpunkt des Cassegrain-Spiegels C. Vom Kryostaten K sind die Superisolierung, der Vakuumanschluß, der Zufluß und der Rückfluß für den flüssigen Stickstoff, das Sicherheitsventil, der Montagehalte M mit Steuer- und Signalleitungen, die Abschirmung AS auf Supraleitungsbasis und der Quarzdom D gezeigt. In diesem miniaturisierten Kryostat K ist sichergestellt, daß alle supraleitenden Teile bei jeder Lage im Raum im flüssigen Stickstoff bleiben. Wichtige Teile sind Sicherheitsventile, Superisolation und ungehinderter Zu-und Abfluß. Die Mikrowellenstrahlung fällt durch den Dom D auf das Sensorfeld SF. Der miniaturisierte Kryostat kann damit schwenkbar ausgebildet werden, wodurch der Sensor in beliebige Richtungen gerichtet werden kann.

Für viele Anwendungen wird diese "flüssig Stickstoffversion" genügen. Für extreme Anforderungen kann eine Erweiterung mit einem nicht gezeigten Helium-Kryostaten erfolgen. Diese arbeitet dann mit einem zusätzlichen Strahlungsschild aus flüssigem Stickstoff. Diese aufwendigere Version steigert die Leistung des Sensors erheblich.

**Patentansprüche**

1. Supraleitendes Element mit folgendem schichtweisen Aufbau:
   - Supraleiter ($S_1$)
   - Barriere (B)
   - Supraleiter ($S_2$)
   - Isolator (I)
   - Supraleiter ($S_3$),

   **dadurch gekennzeichnet,** daß die Barriere (B) eine dichte Schicht mit einer Dicke < 5 nm ist.

2. Supraleitendes Element nach Anspruch 1, **dadurch gekennzeichnet,** daß die Dicke der Barriere (B) für das Einzelelektronentunneln bevorzugt zwischen 2 und 4 nm liegt und für das Josephsontunneln bevorzugt zwischen 1 und 1,5 nm liegt.

3. Supraleitendes Element nach Anspruch 1 oder Anspruch 2, **dadurch gekennzeichnet,** daß die Barriere (B) frei von Mikrolöchern ist.

4. Supraleitendes Element nach einem der vorhergehenden Ansprüche, **dadurch gekennzeichnet,** daß die Barriere (B) eine gleichmäßige Dicke hat.

5. Supraleitendes Element nach einem der vorhergehenden Ansprüche, **dadurch gekennzeichnet,** daß die Barriere (B) im wesentlichen der submikroskopischen Kontur der benachbarten Supraleiter ($S_1$ und $S_2$) folgt.

6. Supraleitendes Element nach einem der vorhergehenden Ansprüche, **dadurch gekennzeichnet,** daß zumindest die Barriere (B) durch Molekularstrahlepitaxie aufgebracht ist.

7. Supraleitendes Element nach einem der vorhergehenden Ansprüche, **dadurch gekennzeichnet,** daß der Supraleiter ($S_3$) Anschlüsse (KStS3) für einen Steuerstrom aufweist, zwischen den Supraleitern ($S_1$ und $S_2$) eine Arbeitsspannung anlegbar ist (Anschlüsse KAS1, KAS2) und der Signalstrom zwischen den Supraleitern ($S_1$ und $S_2$) abgegriffen wird (Anschlüsse KSS1, KSS2), wobei die Anschlüsse (KAS1 und KAS2) identisch mit (KSS1 und KSS2) sein können.

8. Supraleitendes Element nach einem der vorhergehenden Ansprüche, **gekennzeichnet** durch eine Substratgrundplatte (Q), auf der die Schichten - beginnend mit dem Supraleiter ($S_3$) - aufgebracht sind.

9. Supraleitendes Element nach Anspruch 8, **gekennzeichnet** durch einen quaderförmigen Aufbau mit der (strahlungsdurchlässigen) Supraleiterschicht ($S_1$) als Bodenfläche, der Substratgrundplatte (Q) als Deckfläche und mit den Kontaktbahnen (KSS1, KSS2, KStS3, KAS1, KAS2) zu den einzelnen Schichten auf gegenüberliegenden Seitenflächen.

10. Supraleitendes Element nach einem der vorhergehenden Ansprüche, **gekennzeichnet** durch eine Elektronik (SA), die eine kontinuierliche Steuerung im Sinn einer stufenlosen Einstellung von Arbeitsspannung und Energielükke ermöglicht.

11. Sensor für elektromagnetische Strahlung, insbesondere im Infrarot (IR)-Bereich bis zu Dezimeterwellen, mit einem supraleitenden Element eines der Ansprüche 1 bis 10, wobei der erste Supraleiter ($S_1$) für die Strahlung durchlässig ist.

12. Strahlungsquelle für elektromagnetische Strahlung, insbesondere im IR-Bereich bis zu Dezimeterwellen, mit einem supraleitenden Element eines der Ansprüche 1 bis 10, wobei der erste Supraleiter ($S_1$) für die Strahlung durchlässig ist.

13. Empfänger für akustische Wellen, insbesondere im Ultraschallbereich, mit einem supraleitenden Element eines der Ansprüche 1 bis 10.

14. Sender für akustische Wellen, insbesondere im Ultraschallbereich, mit einem supraleitenden Element eines der Ansprüche 1 bis 10.

15. Supraleitendes Schaltelement (Josephson-Schaltelement) für SQUID's oder Rechner mit einem supraleitenden Element eines der Ansprüche 1 bis 10.

EP 0 450 372 A2

# Fig. 1

Signalstrom

S$_1$  B  I  S$_3$

Arbeitsspannung

Steuerstrom für Energielücke

# Fig.2

- Q
- S 3
- I
- S 2
- B
- S 1

# Fig.3

Substrat

- K S S1
- K S S2
- K St S3
- B

- KA S1
- KA S2
- K St S3
- B

# Fig. 4

Steuerung und Auswertung

Steuerstrom

Signalstrom

Präzisions-Stromquelle

Arbeitsspannung

Präzisions-Spannungsquelle

IW

AW

AS

D

EP 0 450 372 A2

Fig.5

SF

KP

SA

EP 0 450 372 A2

# Fig.6

flüssiger Stickstoff Rückfluß

Sicherheitsventil

flüssiger Stickstoff Hinfluß

zur Vakuumpumpe

K

M

AS

Multispektralsensor als
Einzelsensor oder als Feld

D

Superisolierung

Vakuum

C